# EUROPEAN PATENT SPECIFICATION

(11) **EP 2 988 221 B1**
(45) Date of publication and mention of the grant of the patent: **09.08.2017**
(21) Application number: 14870650.0
(22) Date of filing: 27.06.2014
(51) Int. Cl.: G06F 12/02

(54) **CONTROLLER, FLASH MEMORY DEVICE AND METHOD FOR WRITING DATA INTO FLASH MEMORY DEVICE**
STEUERUNG, FLASH-SPEICHERVORRICHTUNG UND VERFAHREN ZUM SCHREIBEN VON DATEN IN EINE FLASH-SPEICHER-VORRICHTUNG
CONTRÔLEUR, DISPOSITIF DE MÉMOIRE FLASH, ET PROCÉDÉ D'ÉCRITURE DE DONNÉES DANS UN DISPOSITIF DE MÉMOIRE FLASH

(43) Date of publication of application: 24.02.2016
(60) Divisional application: 17166143.2
(73) Proprietor: Huawei Technologies Co., Ltd., Longgang District Shenzhen, Guangdong 518129 (CN)
(72) Inventor: ZHANG, Chenyi, Shenzhen Guangdong 518129 (CN); LIN, Chungong, Shenzhen Guangdong 518129 (CN); WEI, Mingchang, Shenzhen Guangdong 518129 (CN)
(74) Representative: Kreuz, Georg Maria
(86) International application number: PCT/CN2014/080984
(87) International publication number: WO 2015/196464

(56) References cited:
- CN-A- 101 930 345
- CN-A- 102 623 052
- CN-A- 102 623 052
- US-A1- 2008 177 956
- US-A1- 2009 259 806
- US-A1- 2012 137 104
- US-A1- 2013 262 942

## Description

### TECHNICAL FIELD

The present invention relates to the field of storage technologies, and in particular, to a controller, a flash memory apparatus, and a method for writing data into a flash memory apparatus.

### BACKGROUND

A Flash Memory (flash memory) apparatus is a non-volatile memory whose storage medium is a Flash granule, and has a characteristic that data does not disappear after a power outage. Therefore, the flash memory apparatus is widely used as an external or internal memory. A flash memory apparatus using a Flash granule as a storage medium may be a solid state disk (full name: Solid State Device, SSD for short), which is also referred to as solid state drive (full name: Solid State Drive, SSD for short), or another memory.

One SSD generally includes multiple flash chips, and each flash chip includes several blocks (block), where each block further includes multiple pages (page). In some cases, a page that is damaged (also referred to as a damaged page) may occur in a block. When an SSD writes data into a block that includes a damaged page, if the block that includes a damaged page is insufficient to store the data, generally a new block is found to store an overflow of the data. Therefore, in the SSD, there are a large number of blocks that have been written with some data but are not filled with data, which reduces space utilization of blocks, and causes a waste of storage space of the SSD.

US 2009/0259806 discloses techniques for flash memory management, including utilizing defect information corresponding to a granularity smaller than a physical erase block size of a flash memory chip.

US 2008/0177956 discloses a page-based failure management system for flash memory includes at least one flash memory device which includes at least one page and at least one operable page.

### SUMMARY

The present invention provides a controller, a flash memory apparatus, and a method for writing data into a flash memory apparatus, which can improve space utilization of a block and save storage space of an SSD.

According to a first aspect, the present invention provides a storage system comprising a controller, where the controller is applied in the storage system, the storage system further comprises a flash memory apparatus, the flash memory apparatus includes a flash chip, the flash chip includes a block, the block includes multiple pages, and at least one of the multiple pages is a damaged page; and the controller includes a communications interface, a cache and a processor;
the communications interface is configured to communicate with the flash memory apparatus;
the cache is configured to temporarily store write requests from a host coupled to the controller and
the processor is configured to: receive capacity information of the block that is sent by the flash memory apparatus;
obtain an effective capacity of the block according to the capacity information of the block, where the effective capacity of the block does not include a capacity of the damaged page;
buffer multiple write requests in the cache until a size of target data included in the multiple write requests reaches the effective capacity of the block;
read target data from the cache; and
send the target data to the flash memory apparatus.

In a first possible implementation manner of the first aspect, the capacity information of the block includes information about the damaged page, the information about the damaged page is used to indicate the capacity of the damaged page, the processor is specifically configured to obtain the effective capacity of the block according to a prestored standard capacity of the block and the capacity of the damaged page, and the effective capacity of the block is the standard capacity of the block minus the capacity of the damaged page.

In a second possible implementation manner of the first aspect, the capacity information of the block includes the effective capacity of the block.

In a third possible implementation manner of the first aspect, the capacity information of the block includes a capacity flag of the block, the controller further includes a memory, and a correspondence between the capacity flag of the block and the effective capacity of the block is stored in the memory; and
the processor is specifically configured to obtain the effective capacity of the block according to the capacity flag of the block, and the correspondence between the capacity flag of the block and the effective capacity of the block.

According to a second aspect, the present invention provides a method for writing data into a flash memory apparatus, where the method is applied in a storage system, the storage system includes a controller and the flash memory apparatus, the flash memory apparatus includes a flash chip, the flash chip includes a block, the block includes multiple pages, and at least one of the multiple pages is a damaged page; and the method includes:
receiving, by the controller, capacity information of the block that is sent by the flash memory apparatus;
obtaining, by the controller, an effective capacity of the block according to the capacity information of the block, where the effective capacity of the block does not include a capacity of the damaged page;
buffering, by the controller, multiple write requests in a cache of the controller until a size of target data included in the multiple write requests reaches the effective capacity of the block;
reading, by the controller, target data from the cache; and
sending, by the controller, the target data to the flash memory apparatus.

In a first possible implementation manner of the third aspect, the capacity information of the block includes information about the damaged page, and the information about the damaged page is used to indicate the capacity of the damaged page; and
the obtaining, by the controller, an effective capacity of the block according to the capacity information of the block includes:
obtaining, by the controller, the effective capacity of the block according to a prestored standard capacity of the block and the capacity of the damaged page, where the effective capacity of the block is the standard capacity of the block minus the capacity of the damaged page.

In a second possible implementation manner of the third aspect, the capacity information of the block includes the effective capacity of the block.

In a third possible implementation manner of the third aspect, the capacity information of the block includes a capacity flag of the block, a correspondence between the capacity flag of the block and the effective capacity of the block is stored in the memory; and
the obtaining, by the controller, an effective capacity of the block according to the capacity information of the block includes:
obtaining, by the controller, the effective capacity of the block according to the capacity flag of the block, and the correspondence between the capacity flag of the block and the effective capacity of the block.

The present invention provides a controller, and a method for writing data into a flash memory apparatus. The controller receives capacity information of a block that is sent by a flash memory apparatus; obtains an effective capacity of the block according to the capacity information of the block, where the effective capacity of the block does not include a capacity of a damaged page; reads target data, where a size of the target data is the effective capacity of the block; and sends the target data to the flash memory apparatus. According to implementation manners of the present invention, if the block has a damaged page, the controller may send, to the flash memory apparatus, the target data whose size is the same as the effective capacity of the block, so that the flash memory apparatus writes the target data into the block. Therefore, according to the present invention, it may be ensured that target data written into a block of the flash memory apparatus fills the block to a greatest extent without overflow data, thereby improving block utilization and saving storage space of an SSD.

In addition, the present invention further provides a flash memory apparatus, and a method for writing data into a flash memory apparatus. The flash memory apparatus collects statistics on capacity information of a block, where the capacity information of the block is used to obtain an effective capacity of the block, and the effective capacity of the block does not include a capacity of a damaged page; sends the capacity information of the block to a controller; receives target data sent by the controller, where a size of the target data is the effective capacity of the block; and writes the target data into the block. The flash memory apparatus may collect the statistics on the capacity information of the block, and send the capacity information of the block to the controller, so that the controller may send, to the flash memory apparatus, the target data whose size is the same as the effective capacity of the block, and the flash memory apparatus writes the target data into the block. Therefore, according to the present invention, it may be ensured that target data written into a block of the flash memory apparatus fills the block to a greatest extent without overflow data, thereby improving block utilization and saving storage space of an SSD.

### BRIEF DESCRIPTION OF DRAWINGS

To describe the technical solutions of the present invention more clearly, in the following accompanying drawings are briefly introduced describing embodiments of the present invention or the prior art. Apparently, the accompanying drawings in the following description show merely some embodiments of the present invention.
FIG. 1 is a schematic structural diagram of a storage system according to an embodiment of the present invention;
FIG. 2 is a schematic structural diagram of a controller according to an embodiment of the present invention;
FIG. 3a is a schematic structural diagram of a storage medium of a flash memory apparatus according to an embodiment of the present invention;
FIG. 3b is a schematic structural diagram of a primary controller of a flash memory apparatus according to an embodiment of the present invention;
FIG. 4 is a schematic flowchart of writing data into a flash memory apparatus according to an embodiment of the present invention;
FIG. 5 is another schematic flowchart of writing data into a flash memory apparatus according to an embodiment of the present invention; and
FIG. 6 is still another schematic flowchart of writing data into a flash memory apparatus according to an embodiment of the present invention.

### DESCRIPTION OF EMBODIMENTS

Embodiments of the present invention provide a controller, a flash memory apparatus, and a method for writing data into a flash memory apparatus, which can improve space utilization of a block and save storage space of an SSD.

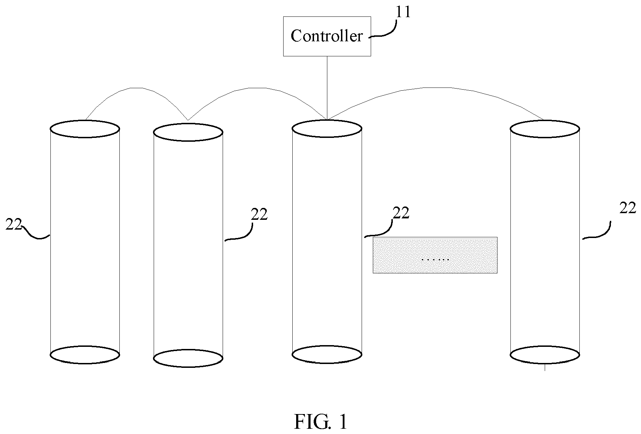

FIG. 1 depicts a schematic structural diagram of a storage system according to an embodiment of the present invention. The storage system shown in FIG. 1 includes a controller 11 and a flash memory apparatus 22. The flash memory apparatus 22 is a storage apparatus that uses a Flash granule as a storage medium, may include a solid state disk (full name: Solid State Device, SSD for short), which is also referred to as solid state drive (Solid State Drive, SSD), and may further include another memory. In this embodiment, the flash memory apparatus 22 is described by using an SSD as an example.

FIG. 1 is only exemplarily illustrative and does not limit a specific networking manner, for example, both cascading tree networking and ring networking may be used as long as the controller 11 and the flash memory apparatus 22 can communicate with each other.

The controller 11 may include any computing device known in the prior art, for example, a server or a desktop computer. An operating system and other application programs are installed in the controller11. The controller 11 may send an input/output (I/O) request to the flash memory apparatus 22. For example, a write data request is sent to the flash memory apparatus 22, so that the flash memory apparatus 22 writes to-be-written data carried in the write data request into the storage medium of the flash memory apparatus 22.

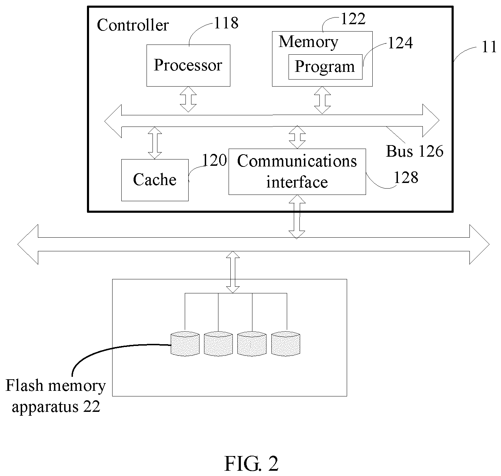

Referring to FIG. 2, FIG. 2 is a schematic structural diagram of a controller 11 according to an embodiment of the present invention. As shown in FIG. 2, the controller 11 mainly includes a processor (processor) 118, a buffer (cache) 120, a memory (memory) 122, a communications bus (a bus for short) 126, and a communications interface (Communication Interface) 128. The processor 118, the cache 120, the memory 122, and the communications interface 128 complete mutual communication by using the communications bus 126.

The communications interface 128 is configured to communicate with a host (not shown in the figure) or a flash memory apparatus 22.

The memory 122 is configured to store a program 124, and the memory 122 may include a high-speed RAM memory, or may include a non-volatile memory (non-volatile memory), for example, at least one disk memory. It may be understood that the memory 122 may be any non-transitory (non-transitory) machine-readable medium that can store program code, such as a random-access memory (Random-Access Memory, RAM), a magnetic disk, a hard disk, an optical disc, a solid state disk (Solid State Disk, SSD), or a non-volatile memory.

Specifically, the program 124 may include program code, where the program code includes a computer operation instruction.

The cache 120 (Cache) is configured to temporarily stored data received from the host or data read from the flash memory apparatus 22. The cache 120 may be any non-transitory (non-transitory) machine-readable medium that can store data, such as a RAM, a ROM, a flash memory (Flash memory), or a solid state disk (Solid State Disk, SSD), which is not limited herein. For example, when receiving a write data request sent by the host, the controller 11 may store the write data request in the cache 120, and then the processor 118 processes the write data request. Optionally, when receiving one write data request sent by the host, the controller 11 may first store the write data request in the cache 120; then read the one write data request from the cache 120, and send the one write data request to the flash memory apparatus 22 for processing. Alternatively, when receiving multiple write data requests sent by the host, the controller 11 may temporarily store the multiple write data requests in the cache 120; when to-be-written data carried in the multiple write data requests stored in the cache 120 reaches a set threshold, the controller 11 may send the to-be-written data carried in the multiple write data requests to the flash memory apparatus 22 for processing.

In addition, the memory 122 and the cache 120 may be disposed together or separately, which is not limited in this embodiment of the present invention.

The processor 118 may be a central processing unit CPU, an application specific integrated circuit ASIC (Application Specific Integrated Circuit), or one or more integrated circuits configured to implement this embodiment of the present invention. In this embodiment of the present invention, the processor 118 may be configured to receive a write data request or a read data request from the host, process the write data request or the read data request, send the write data request or the read data request to the flash memory apparatus 22, and perform other operations.

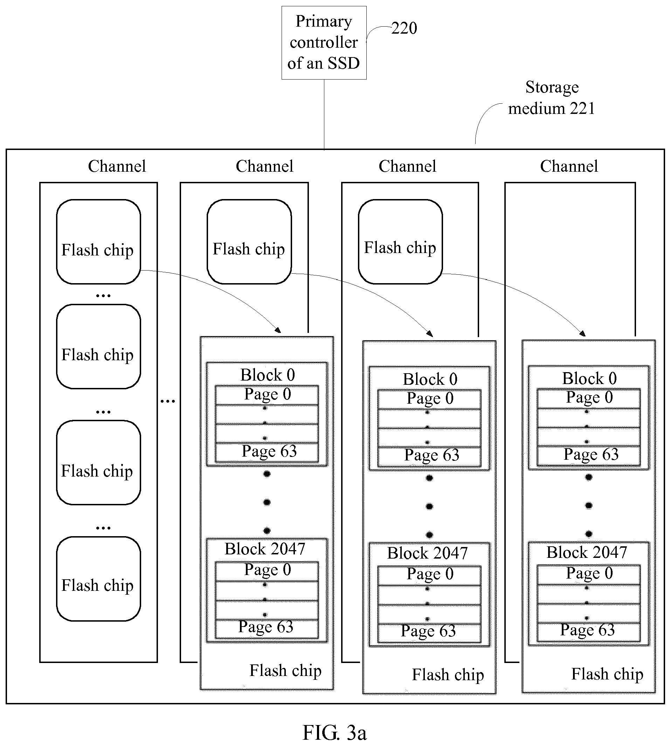

Referring to FIG. 3a, FIG. 3a is a schematic structural diagram of a flash memory apparatus 22 according to an embodiment of the present invention. In this embodiment, the flash memory apparatus 22 is described by using an SSD as an example.

As shown in FIG. 3a, the flash memory apparatus 22 includes a primary controller 220 and a storage medium 221. The primary controller 220 is configured to execute a write data request or a read data request sent by a controller 11, and operations such as collecting statistics on damaged pages. The primary controller 220 herein is a primary controller of an SSD.

The storage medium 221 generally includes several flash (Flash) chips. In an SSD, channels (channel) are used to connect the several flash chips together. Concurrent processing of write data requests may be implemented for the channels. Four channels shown in FIG. 3a are used as an example. If the primary controller 220 receives four write data requests sent by the controller 11, the four channels each may execute a write data request, thereby improving efficiency in processing write data requests. In addition, according to this embodiment of the present invention, concurrent processing of write data requests may also be implemented for multiple concurrent units on one channel, which is not limited herein.

Each flash chip includes several blocks (block), and an erase operation performed by an SSD is executed with a block as a unit. For example, when the SSD needs to perform garbage collection, valid data in a block may be first moved to another new block, and then all data (including valid data and invalid data) stored in the original block is erased. In this embodiment of the present invention, valid data in a block refers to data that is stored in the block and has not been modified, and this part of data may be read; and invalid data in a block refers to data that is stored in the block and has been modified, and this part of data cannot be read. A person skilled in the art may learn that due to an erase feature of a flash granule, data stored in a block may not be directly modified like a common mechanical hard drive. When data in a block needs to be modified, the primary controller 220 finds a new block and writes modified data into the new block, and the data in the original block becomes invalid data. When the SSD performs garbage collection, the invalid data is erased.

It may be learned from FIG. 3a that each block may include several pages. In some cases, damage may occur in a page in a block, and a page in which damage occurs is referred to as damaged page in this embodiment of the present invention. When there is a damaged page in a block, an actual capacity of the block is less than a capacity of a block that does not include a damaged page. In this embodiment of the present invention, an actual capacity of a block is referred to as an effective capacity. For example, a standard capacity of a block is 1 M, and a size of each page is 4 KB. When there is one damaged page in the block, an effective capacity of the block is 1 M minus 4 KB. In this embodiment of the present invention, a standard capacity of a block refers to a capacity of a blank block that does not include a damaged page, and a blank block refers to a block that is erased clean and includes neither valid data nor invalid data. An effective capacity of a block is equal to a standard capacity of the block minus a capacity of damaged pages, where the capacity of damaged pages is equal to a product of a size of each damaged page and the number of damaged pages.

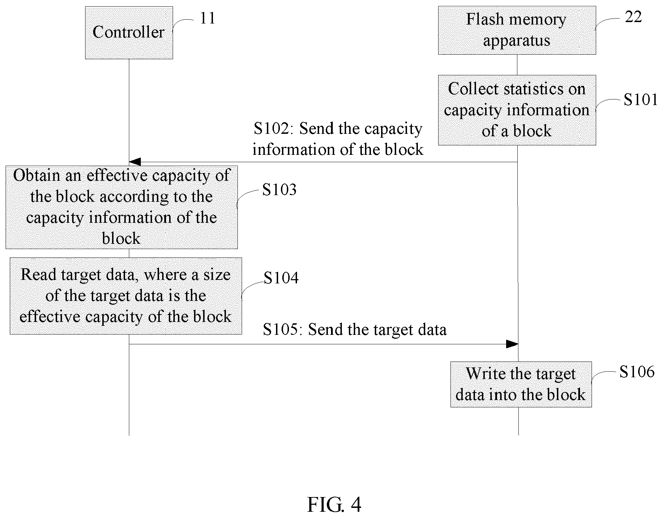

In this embodiment of the present invention, a standard capacity of a block may be prestored in the controller 11 and used by the controller 11 to send, to the flash memory apparatus 22, target data whose size is the same as the standard capacity. A standard capacity of each block is the N^{th} power (M) of 2, where N is a positive integer. Standard capacities of blocks may be the same or different. When standard capacities of blocks are different, values of N may be different. In this case, a standard capacity of a largest block may be considered as the standard capacity used in any implementation manner of the embodiments of the present invention that are shown in FIG. 4 to FIG. 6.

In addition, in this embodiment of the present invention, when the SSD executes a write data request, data is also written by using a page as a unit. For example, the controller 11 sends a write data request to the primary controller 220, where the write data request carries a segment of logical block addresses (Logical Block Address, LBA) and target data, and the LBAs are addresses that can be accessed by the controller 11. When receiving the write data request, the primary controller 220 may write the target data into a block according to a predetermined policy, and addresses of multiple pages into which the target data is written are addresses for actually storing the target data, and are also referred to as physical address. The SSD may establish and store a correspondence between the segment of LBAs and the addresses of the multiple pages. When the controller 11 subsequently sends a read data request to the primary controller 220 and requests to read the target data, the read data request carries the LBAs. In this case, the primary controller 220 may read out the target data according to the LBAs and the correspondence between the LBAs and the physical addresses, and return the target data to the controller 11.

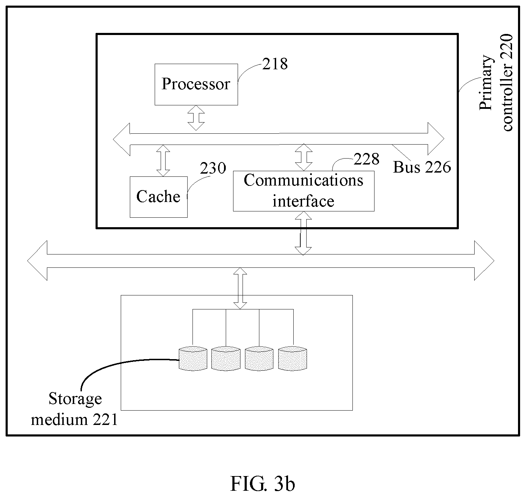

The following introduces a structure and a function of a primary controller 220. Referring to FIG. 3b, FIG. 3b is a schematic structural diagram of a primary controller 220 of a flash memory apparatus 22 according to an embodiment of the present invention.

The primary controller 220 mainly includes a processor (processor) 218, a cache (cache) 230, a communications bus (a bus for short) 226, and a communications interface (Communication Interface) 228. The processor 218, the cache 230, and the communications interface 228 complete mutual communication by using the communications bus 226.

The communications interface 228 is configured to communicate with a controller 11 and a storage medium 221.

The cache 230 is configured to temporarily stored data received from the controller 11 and data read from the storage medium 221. The cache 230 may be any non-transitory (non-transitory) machine-readable medium that can store data, such as a RAM, a ROM, a flash memory (Flash memory), or a solid state disk (Solid State Disk, SSD), which is not limited herein. For example, when a write data request sent by the controller 11 is received, the write data request may be stored in the cache 230 and is processed by the processor 218. In addition, in some application scenarios, the cache 230 may also be disposed outside the primary controller 220.

The processor 218 may be a central processing unit CPU, an application specific integrated circuit ASIC (Application Specific Integrated Circuit), or one or more integrated circuits configured to implement this embodiment of the present invention. In this embodiment of the present invention, the processor 218 may be configured to receive a write data request or a read data request from the controller 11, process the write data request or the read data request, send the write data request or the read data request to the storage medium 221, and perform other operations.

The processor 218 may further include a cache (not shown in the figure), configured to store various program instructions. For example, the cache may include a flash translation layer (Flash Translation Layer, FTL). The processor 218 may perform an operation such as collecting statistics on damaged pages by using the FTL, and store a result of the collecting statistics on damaged pages in configuration information of the FTL. Alternatively, the processor 218 may achieve a similar function by using another software module. Therefore, any software module that has a function similar to that of the FTL and may perform an operation such as collecting statistics on damaged pages and store a result of the collecting statistics on damaged pages in configuration information of the software module falls into the protection scope of embodiments of the present invention.

The following introduces a method procedure for writing data into a flash memory apparatus according to an embodiment of the present invention. The method for writing data into a flash memory apparatus in this embodiment of the present invention may be applied in the storage system shown in FIG. 1, the controller 11 shown in FIG. 2, and the flash memory apparatus (for example, an SSD) shown in FIG. 3a and FIG. 3b. The flash memory apparatus includes a block, and the block includes multiple pages in which at least one page is a damaged page. As shown in FIG. 4, the method includes the following steps:
Step S101: A flash memory apparatus 22 collects statistics on capacity information of a block. Specifically, a primary controller 220 may collect statistics on damaged pages in the block by using an FTL, and save a statistical result in configuration information of the FTL.

Herein, the capacity information of the block may refer to capacity information of one block in an SSD, or capacity information of multiple or all blocks in an SSD. To facilitate description, one block is used as an example for description in this embodiment of the present invention.

The capacity information of the block in this embodiment of the present invention may be used to obtain, by the primary controller 220 or a controller 11, an effective capacity of the block.

Optionally, the capacity information of the block may include the number of damaged pages included in the block. When the primary controller 220 obtains, through statistics collection, the number of the damaged pages included in the block, the effective capacity of the block is equal to a standard capacity of the block minus a capacity of the damaged pages, where the capacity of the damaged pages is equal to a product of the number of the damaged pages and a size of a damaged page.

Optionally, the capacity information of the block may include the capacity of the damaged pages included in the block.

Optionally, the capacity information of the block may be the effective capacity of the block.

Optionally, the capacity information of the block may be a capacity flag of the block, or other information used to obtain the effective capacity of the block. This embodiment of the present invention imposes no limitation on a form and content of the capacity information of the block. Step S102: The flash memory apparatus 22 sends the capacity information of the block to the controller 11.

Specifically, the primary controller 220 of the flash memory apparatus 22 may send the capacity information of the block to a processor 118 of the controller 11 through a communications interface 228 of the controller 11.

One optional implementation manner is that the controller 11 may send a query command to the flash memory apparatus 22 periodically or in real time, where the query command is used to query the capacity information of the block. After receiving the query command, the flash memory apparatus 22 starts to execute step S101, and sends the capacity information of the block to the controller 11 after the execution is completed. Specifically, the processor 118 of the controller 11 may send the query command to the flash memory apparatus 22.

Another optional implementation manner is that the primary controller 220 periodically executes step S101, and sends the capacity information of the block to the controller 11 each time after the execution is completed. Alternatively, the primary controller 220 periodically executes step S101, and the primary controller 220 compares a current statistical result with a previous statistical result. When finding that the capacity information of the block changes, the primary controller 220 sends the current statistical result to the controller 11. It should be noted that this embodiment of the present invention imposes no limitation on a length of a period, and the length of a period may be adjusted according to a user requirement in an actual application. Step S103: The controller 11 obtains the effective capacity of the block according to the capacity information of the block, where the effective capacity of the block does not include the capacity of the damaged pages.

Specifically, the processor 118 of the controller 11 may obtain the effective capacity of the block according to the capacity information of the block.

When the capacity information of the block includes the number of the damaged pages included in the block, the controller 11 may multiply the number of the damaged pages by the size of a damaged page to obtain the capacity of the damaged pages in the block, and then subtract the capacity of the damaged pages from the prestored standard capacity of the block, to obtain the effective capacity of the block.

When the capacity information of the block includes the capacity of the damaged pages included in the block, the controller 11 may subtract the capacity of the damaged pages from the prestored standard capacity of the block to obtain the effective capacity of the block.

When the capacity information of the block is the effective capacity of the block, the controller 11 may directly obtain the effective capacity of the block.

When the capacity information of the block is a capacity flag of the block, the controller 11 may obtain the effective capacity of the block according to the capacity flag and a correspondence between a capacity flag and an effective capacity. In this embodiment of the present invention, to obtain the effective capacity of the block, the controller 11 may prestore, in a memory 122 of the controller 11, a correspondence between a capacity flag of each block and an effective capacity of each block, or prestore, in a memory 122, a correspondence between a capacity flag of each block and other capacity information.

Step S104: The controller 11 reads target data, where a size of the target data is the effective capacity of the block.

Specifically, step S104 may be executed by the processor 118 of the controller 11. The processor 118 reads out the target data from a cache 120, where the size of the target data is equal to the effective capacity of the block. It should be noted that the size of the target data may not be necessarily equal to the effective capacity of the block but may be slightly less than the effective capacity of the block.

The target data stored in the cache 120 may be from to-be-written data carried in a write data request sent by a host, and may be to-be-written data carried in one write data request or to-be-written data carried in multiple write data requests.

Step S105: The controller 11 sends the target data to the flash memory apparatus 22.

Specifically, the processor 118 sends, through a communications interface 128, the to-be-written data read out in step S104 to the flash memory apparatus 22. One optional implementation manner is that the processor 118 generates a new write data request, where the new write data request includes the target data; another optional implementation manner is that the processor 118 generates multiple new write data requests, where the multiple new write data requests each includes a part of the target data; and still another optional implementation manner is that the processor 118 directly forwards a write data request from a host to the flash memory apparatus 22, where data carried in the write data request from the host is the target data.

Step S106: The flash memory apparatus 22 writes the target data into the block.

The size of the target data is the effective capacity of the block; therefore, after the primary controller 220 writes the target data into another page of the block except the damaged pages, the block is exactly fully filled.

In this embodiment of the present invention, a flash memory apparatus 22 sends capacity information of a block to a controller 11, where the capacity information of the block is used to obtain an effective capacity of the block, the controller 11 may obtain the effective capacity of the block according to the capacity information of the block, read target data whose size is the same as the effective capacity of the block, and send the target data to the flash memory apparatus 22, and the flash memory apparatus 22 writes the target data into the block. According to an implementation manner of this embodiment of the present invention, in a case in which the block has a damaged page, it may be ensured that the target data written into the block fills the block to a greatest extent without overflow data, thereby improving block utilization.

In the foregoing embodiment, another implementation manner may be that the size of the target data read by the processor 118 from the cache 120 may be a sum of effective capacities of several blocks. An example in which the size of the target data may be a sum of effective capacities of four blocks is used. The processor 118 may generate four write data requests, where target data carried in each of the write data requests is equal to an effective capacity of one block among four blocks. Then the processor 118 sends the generated four write data requests to the primary controller 220, and the primary controller 220 writes the generated four write data requests into blocks of four channels. According to this implementation manner, write data requests may be concurrently executed for channels of the flash memory apparatus 22, thereby improving efficiency in writing data. In addition, in this embodiment of the present invention, concurrent processing of multiple write data requests may also be implemented for multiple concurrent units on one channel.

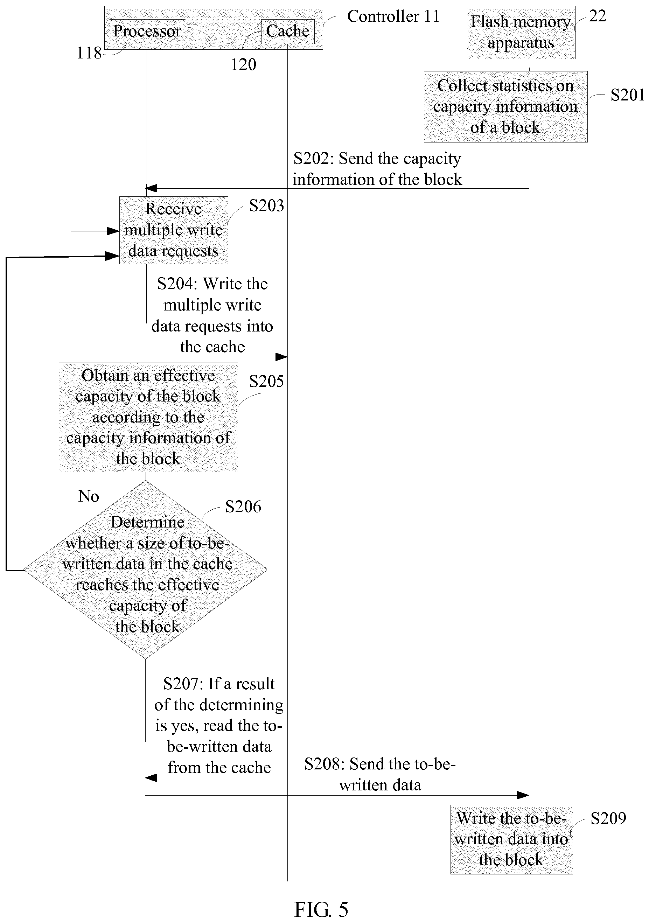

The following introduces another method procedure for writing data into a flash memory apparatus according to an embodiment of the present invention. The method may be applied in the storage system shown in FIG. 1, the controller 11 shown in FIG. 2, and the flash memory apparatus (for example, an SSD) shown in FIG. 3a and FIG. 3b. The flash memory apparatus includes a block, and the block includes multiple pages in which at least one page is a damaged page. As shown in FIG. 5, the method includes the following steps:
Step S201: Step S201 is the same as step S101 in the embodiment shown in FIG. 4, and reference may be made to the description in step S101.

Step S202: Step S202 is the same as step S102 in the embodiment shown in FIG. 4, and reference may be made to the description in step S102.

Step S203: A processor 118 receives multiple write data requests.

The processor 118 may receive multiple write data requests from a host or another device, where each of the write data requests carries data to be written into the flash memory apparatus 22 (to-be-written data for short).

It should be noted that there is no sequence between step S203 and step S201 or step S202, and step S203 may be executed before step S201 and step S202, after step S201 and step S202, or simultaneously with step S201 and step S202.

Step S204: The processor 118 writes the received multiple write data requests into a cache 120. Because each of the write data requests carries to-be-written data, the to-be-written data is also stored in the cache 120.

Step S205: Step S205 is the same as step S103 in the embodiment shown in FIG. 4, and reference may be made to the description in step S103.

Step S206: The processor 118 determines whether a size of the to-be-written data stored in the cache 120 reaches the effective capacity of the block; and if the size of the to-be-written data stored in the cache 120 reaches the effective capacity of the block, executes step S207; if the size of the to-be-written data stored in the cache 120 does not reach the effective capacity of the block, executes step S203.

When a preset condition is met, the processor 118 may determine whether the size of the to-be-written data carried in the multiple write data requests and stored in the cache 120 reaches the effective capacity of the block. The preset condition herein may be a moment at which a preset time interval starts (for example, triggering by a timer) or another triggering condition, which is not limited herein.

If the size of the to-be-written data carried in the multiple write data requests and stored in the cache 120 has not reached the effective capacity of the block, the processor 118 may temporarily wait for a period of time instead of processing the write data requests in the cache 120. During this period of time, the processor 118 may continue to receive a write data request from the host until the size of the to-be-written data stored in the cache 120 reaches the effective capacity of the block.

Step S207: The processor 118 reads, from the cache 120, the target data carried in the multiple write data requests.

If the size of the to-be-written data carried in the multiple write data requests and stored in the cache 120 has reached the effective capacity of the block, the processor 118 may read, from the cache 120, the to-be-written data carried in the multiple write data requests. It may be understood that, when the size of the to-be-written data carried in the multiple write data requests and stored in the cache 120 has reached the effective capacity of the block, the to-be-written data carried in the multiple write data requests and stored in the cache 120 at this moment is the target data in step S104 to step S106 in the embodiment shown in FIG. 4.

Step S208: Step S208 is the same as step S105 in the embodiment shown in FIG. 4, and reference may be made to the description in step S105.

Step S209: Step S209 is the same as step S106 in the embodiment shown in FIG. 4, and reference may be made to the description in step S106.

In this embodiment of the present invention, a flash memory apparatus 22 sends capacity information of a block to a controller 11, where the capacity information of the block is used to obtain an effective capacity of the block, the controller 11 may obtain the effective capacity of the block according to the capacity information of the block, read target data whose size is the same as the effective capacity of the block, and send the target data to the flash memory apparatus 22, and the flash memory apparatus 22 writes the target data into the block. According to an implementation manner of this embodiment of the present invention, in a case in which the block has a damaged page, it may be ensured that the target data written into the block fills the block to a greatest extent without overflow data, thereby improving block utilization.

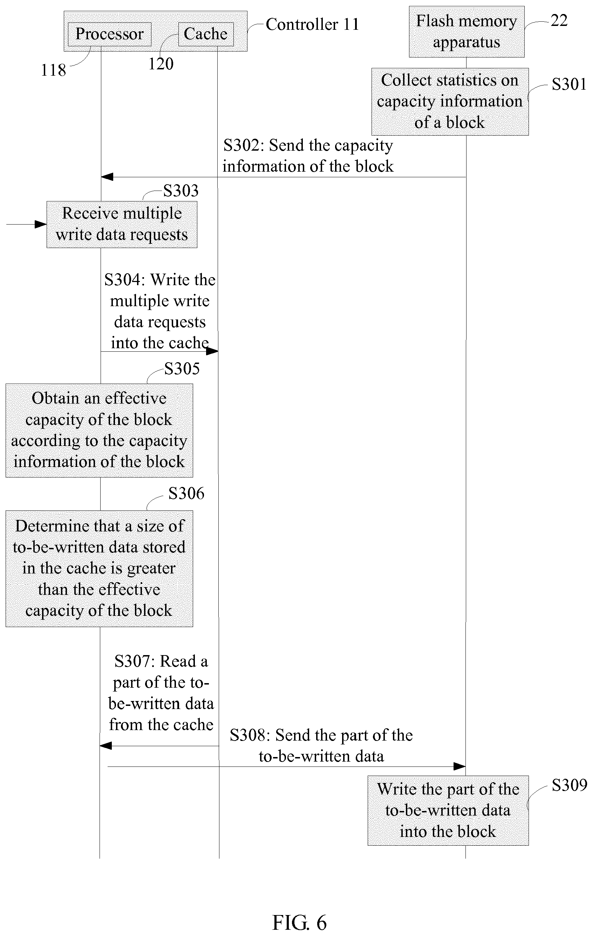

The following introduces still another method procedure for writing data into a flash memory apparatus according to an embodiment of the present invention. The method may be applied in the storage system shown in FIG. 1, the controller 11 shown in FIG. 2, and the flash memory apparatus (for example, an SSD) shown in FIG. 3a and FIG. 3b. The flash memory apparatus includes a block, and the block includes multiple pages in which at least one page is a damaged page. As shown in FIG. 6, the method includes the following steps:
Step S301: Step S301 is the same as step S101 in the embodiment shown in FIG. 4, and reference may be made to the description in step S101.

Step S302: Step S302 is the same as step S102 in the embodiment shown in FIG. 4, and reference may be made to the description in step S102.

Step S303: Step S303 is the same as step S203 in the embodiment shown in FIG. 5, and reference may be made to the description in step S203.

Step S304: Step S304 is the same as step S204 in the embodiment shown in FIG. 5, and reference may be made to the description in step S204.

Step S305: Step S305 is the same as step S205 in the embodiment shown in FIG. 5, and reference may be made to the description in step S205.

Step S306: The processor 118 determines that a size of the to-be-written data stored in the cache 120 is greater than the effective capacity of the block.

When a preset condition is met, the processor 118 may determine that a size of the to-be-written data that is carried in the multiple write data requests and stored in the cache 120 is greater than the effective capacity of the block. The preset condition herein may be that a preset time interval arrives (for example, triggering by a timer) or another triggering condition, which is not limited herein.

Step S307: The processor 118 reads a part of the to-be-written data from the cache 120, where a size of the part of the to-be-written data is the effective capacity of the block.

When the size of the to-be-written data carried in the multiple write data requests is greater than the effective capacity of the block, the processor 118 may read the part of the to-be-written data from the cache 120, where the size of the part of the to-be-written data is the effective capacity of the block. In this case, the part of the to-be-written data is the target data in step S104 to step S106 in the embodiment shown in FIG. 4.

Step S308: Step S308 is the same as step S105 in the embodiment shown in FIG. 4, and reference may be made to the description in step S105.

Step S309: Step S309 is the same as step S106 in the embodiment shown in FIG. 4, and reference may be made to the description in step S106.

In this embodiment of the present invention, a flash memory apparatus 22 sends capacity information of a block to a controller 11, where the capacity information of the block is used to obtain an effective capacity of the block, the controller 11 may obtain the effective capacity of the block according to the capacity information of the block, read target data whose size is the same as the effective capacity of the block, and send the target data to the flash memory apparatus 22, and the flash memory apparatus 22 writes the target data into the block. According to an implementation manner of this embodiment of the present invention, in a case in which the block has a damaged page, it may be ensured that the target data written into the block fills the block to a greatest extent without overflow data, thereby improving block utilization.

Further, in any one of the foregoing embodiments shown in FIG. 4 to FIG. 6, addresses of multiple pages in a block into which the target data is written are physical addresses. After the primary controller 220 writes the target data into the block, the primary controller 220 may establish and store a correspondence between a segment of logical block addresses (Logical Block Address, LBA) of the target data and physical addresses, which is used by the controller 11 to read the target data subsequently.

It may be learned from any one of the embodiments shown in FIG. 4 to FIG. 6 that the target data is stored in one block; therefore, physical addresses thereof are a segment of consecutive physical space. If the target data is changed into other data subsequently, the target data stored in the block becomes invalid data, and an erase operation may be directly performed on the block without migrating valid data, thereby improving efficiency in garbage collection.

In addition, if the controller 11 needs to perform defragment on the segment of LBAs corresponding to the target data, according to a technical principle of defragment, the controller 11 may send a data migration command to the primary controller 220, where the data migration command carries the LBAs. After receiving the data migration command, the primary controller 220 may obtain, according to the correspondence between the LBAs and the physical addresses, the target data from pages in the block, and migrate the target data to another block, to complete the defragment operation. After the defragment operation is completed, the block is also accordingly erased clean and may receive new data, and garbage collection does not need to be performed on the block again. It may be seen that efficiency in garbage collection may further be improved by combining any one of the embodiments shown in FIG. 4 to FIG. 6 and the defragment operation.

A person of ordinary skill in the art may understand that, each aspect of the present invention or a possible implementation manner of each aspect may be specifically implemented as a system, a method, or a computer program product. Therefore, each aspect of the present invention or a possible implementation manner of each aspect may use forms of hardware only embodiments, software only embodiments (including firmware, resident software, and the like), or embodiments with a combination of software and hardware, which are uniformly referred to as "circuit", "module", or "system" herein. In addition, each aspect of the present invention or the possible implementation manner of each aspect may take a form of a computer program product, where the computer program product refers to computer-readable program code stored in a computer-readable medium.

The computer-readable medium may be a computer-readable signal medium or a computer-readable storage medium. The computer-readable storage medium includes but is not limited to an electronic, magnetic, optical, electromagnetic, infrared, or semi-conductive system, device, or apparatus, or any appropriate combination thereof, such as a random access memory (RAM), a read-only memory (ROM), an erasable programmable read only memory (EPROM or flash memory), an optical fiber, and a compact disc read only memory (CD-ROM).

A processor in a computer reads computer-readable program code stored in a computer-readable medium, so that the processor can execute a function and an action specified in each step or a combination of steps in a flowchart; an apparatus is generated to implement a function and an action specified in each block or a combination of blocks in a block diagram.

All computer-readable program code may be executed on a user computer, or some may be executed on a user computer as a standalone software package, or some may be executed on a computer of a user while some is executed on a remote computer, or all the code may be executed on a remote computer or a server. It should also be noted that, in some alternative implementation solutions, each step in the flowcharts or functions specified in each block in the block diagrams may not occur in the illustrated order. For example, two consecutive steps or two blocks in the illustration, which are dependent on an involved function, may in fact be executed substantially at the same time, or these blocks may sometimes be executed in reverse order.

A person of ordinary skill in the art may be aware that, in combination with the examples described in the embodiments disclosed in this specification, units and algorithm steps may be implemented by electronic hardware or a combination of computer software and electronic hardware. Whether the functions are executed by hardware or software depends on particular applications and design constraint conditions of the technical solutions. A person skilled in the art may use different methods to implement the described functions for each particular application, but it should not be considered that the implementation goes beyond the scope of the present invention.

The foregoing descriptions are merely specific implementation manners of the present invention, but are not intended to limit the present invention.

## Claims

1. A storage system comprising a controller (11), wherein the controller is applied in the storage system, the storage system further comprises a flash memory apparatus (22), the flash memory apparatus (22) comprises a flash chip, the flash chip comprises a block, the block comprises multiple pages, and at least one of the multiple pages is a damaged page;
the controller (11) comprises a communications interface (128), a cache (120) and a processor (118);
the communications interface (128) is configured to communicate with the flash memory apparatus (22);
the cache (120) is configured to temporarily store write requests from a host coupled to the controller (11) and
the processor (118) is configured to:
receive capacity information of the block that is sent by the flash memory apparatus (22);
obtain an effective capacity of the block according to the capacity information of the block, wherein the effective capacity of the block does not comprise a capacity of the damaged page;
buffer multiple write requests in the cache (120) until a size of target data included in the multiple write requests reaches the effective capacity of the block;
read the target data from the cache (120); and
send the target data to the flash memory apparatus (22).

2. The storage system according to claim 1, wherein the capacity information of the block comprises information about the damaged page, the information about the damaged page is used to indicate the capacity of the damaged page, the processor (118) is specifically configured to obtain the effective capacity of the block according to a prestored standard capacity of the block and the capacity of the damaged page, and the effective capacity of the block is the standard capacity of the block minus the capacity of the damaged page.

3. The storage system according to claim 1, wherein the capacity information of the block comprises the effective capacity of the block.

4. The storage system according to claim 1, wherein the capacity information of the block comprises a capacity flag of the block, the controller (11) further comprises a memory (122), and a correspondence between the capacity flag of the block and the effective capacity of the block is stored in the memory; and
the processor (118) is specifically configured to obtain the effective capacity of the block according to the capacity flag of the block, and the correspondence between the capacity flag of the block and the effective capacity of the block.

5. A method for writing data into a flash memory apparatus (22), wherein the method is applied in a storage system, the storage system comprises a controller (11) and the flash memory apparatus (22), the flash memory apparatus (22) comprises a flash chip, the flash chip comprises a block, the block comprises multiple pages, and at least one of the multiple pages is a damaged page; and the method comprises:
receiving (S102, S202, S302), by the controller (11), capacity information of the block that is sent by the flash memory apparatus (22);
obtaining (S103), by the controller (11), an effective capacity of the block according to the capacity information of the block, wherein the effective capacity of the block does not comprise a capacity of the damaged page;
buffering, by the controller (11), multiple write requests in a cache (120) of the controller (11) until a size of target data included in the multiple write requests reaches the effective capacity of the block;
reading (S104), by the controller (11), the target data from the cache (120); and
sending (S105), by the controller (11), the target data to the flash memory apparatus (22).

6. The method according to claim 5, wherein the capacity information of the block comprises information about the damaged page, and the information about the damaged page is used to indicate the capacity of the damaged page; and
the obtaining (S103), by the controller (11), an effective capacity of the block according to the capacity information of the block comprises:
obtaining, by the controller (11), the effective capacity of the block according to a prestored standard capacity of the block and the capacity of the damaged page, wherein the effective capacity of the block is the standard capacity of the block minus the capacity of the damaged page.

7. The method according to claim 5, wherein the capacity information of the block comprises the effective capacity of the block.

8. The method according to claim 5, wherein the capacity information of the block comprises a capacity flag of the block, a correspondence between the capacity flag of the block and the effective capacity of the block is stored in the memory; and
the obtaining (S103), by the controller (11), an effective capacity of the block according to the capacity information of the block comprises:
obtaining, by the controller, the effective capacity of the block according to the capacity flag of the block, and the correspondence between the capacity flag of the block and the effective capacity of the block.

## Patentansprüche

1. Speichersystem, umfassend eine Steuerung (11), wobei die Steuerung in dem Speichersystem angewandt wird, das Speichersystem ferner eine Flash-Speicher-Vorrichtung (22) umfasst, die Flash-Speicher-Vorrichtung (22) einen Flash-Chip umfasst, der Flash-Chip einen Block umfasst, der Block mehrere Seiten umfasst und mindestens eine der mehreren Seiten eine beschädigte Seite ist;
wobei die Steuerung (11) eine Kommunikationsschnittstelle (12), einen Zwischenspeicher (120) und einen Prozessor (118) umfasst;
wobei die Kommunikationsschnittstelle (128) konfiguriert ist, mit der Flash-Speicher-Vorrichtung (22) zu kommunizieren;
der Zwischenspeicher (120) konfiguriert ist, Schreibanforderungen von einem an die Steuerung (11) gekoppelten Wirt vorübergehend zu speichern, und
der Prozessor (118) konfiguriert ist zum:
Empfangen von Kapazitätsinformationen des Blocks, die von der Flash-Speicher-Vorrichtung (22) gesandt werden;
Erhalten einer effektiven Kapazität des Blocks gemäß den Kapazitätsinformationen des Blocks, wobei die effektive Kapazität des Blocks eine Kapazität der beschädigten Seite nicht umfasst;
Zwischenspeichern mehrerer Schreibanforderungen in dem Zwischenspeicher (120), bis eine Größe von Zieldaten, die in den mehreren Schreibanforderungen enthalten sind, die effektive Kapazität des Blocks erreicht;
Lesen der Zieldaten aus dem Zwischenspeicher (120); und
Senden der Zieldaten an die Flash-Speicher-Vorrichtung (22).

2. Speichersystem nach Anspruch 1, wobei die Kapazitätsinformationen des Blocks Informationen über die beschädigte Seite umfassen, die Informationen über die beschädigte Seite verwendet werden, die Kapazität der beschädigten Seite anzugeben, der Prozessor (118) spezifisch konfiguriert ist, die effektive Kapazität des Blocks gemäß einer im Voraus gespeicherten Standardkapazität des Blocks und die Kapazität der beschädigten Seite zu erhalten, und die effektive Kapazität des Blocks die Standardkapazität des Blocks minus der Kapazität der beschädigten Seite ist.

3. Speichersystem nach Anspruch 1, wobei die Kapazitätsinformationen des Blocks die effektive Kapazität des Blocks umfassen.

4. Speichersystem nach Anspruch 1, wobei die Kapazitätsinformationen des Blocks ein Kapazitätskennzeichen des Blocks umfassen, die Steuerung (11) ferner einen Speicher (122) umfasst und eine Korrespondenz zwischen dem Kapazitätskennzeichen des Blocks und der effektiven Kapazität des Blocks in dem Speicher gespeichert wird; und der Prozessor (118) spezifisch konfiguriert ist, die effektive Kapazität des Blocks gemäß dem Kapazitätskennzeichen des Blocks und die Korrespondenz zwischen dem Kapazitätskennzeichen des Blocks und der effektiven Kapazität des Blocks zu erhalten.

5. Verfahren zum Schreiben von Daten in eine Flash-Speicher-Vorrichtung (22), wobei das Verfahren in einem Speichersystem angewandt wird, das Speichersystem eine Steuerung (11) und die Flash-Speicher-Vorrichtung (22) umfasst, die Flash-Speicher-Vorrichtung (22) einen Flash-Chip umfasst, der Flash-Chip einen Block umfasst, der Block mehrere Seiten umfasst und mindestens eine der mehreren Seiten eine beschädigte Seite ist; und das Verfahren umfasst:
Empfangen (S102, S202, S302), durch die Steuerung (11), von Kapazitätsinformationen des Blocks, die von der Flash-Speicher-Vorrichtung (22) gesandt werden;
Erhalten (S103), durch die Steuerung (11), einer effektiven Kapazität des Blocks gemäß den Kapazitätsinformationen des Blocks, wobei die effektive Kapazität des Blocks eine Kapazität der beschädigten Seite nicht umfasst;
Zwischenspeichern, durch die Steuerung (11), von mehreren Schreibanforderungen in einem Zwischenspeicher (120) der Steuerung (11), bis eine Größe von Zieldaten, die in den mehreren Schreibanforderungen enthalten sind, die effektive Kapazität des Blocks erreicht;
Lesen (S104), durch die Steuerung (11), der Zieldaten aus dem Zwischenspeicher (120); und
Senden (S105), durch die Steuerung (11), der Zieldaten an die Flash-Speicher-Vorrichtung (22).

6. Verfahren nach Anspruch 5, wobei die Kapazitätsinformationen des Blocks Informationen über die beschädigte Seite umfassen und die Informationen über die beschädigte Seite verwendet werden, die Kapazität der beschädigten Seite anzugeben;
und
das Erhalten (S103), durch die Steuerung (11), einer effektiven Kapazität des Blocks gemäß den Kapazitätsinformationen des Blocks umfasst:
Erhalten, durch die Steuerung (11), der effektiven Kapazität des Blocks gemäß einer im Voraus gespeicherten Standardkapazität des Blocks und der Kapazität der beschädigten Seite, wobei die effektive Kapazität des Blocks die Standardkapazität des Blocks minus der Kapazität der beschädigten Seite ist.

7. Verfahren nach Anspruch 5, wobei die Kapazitätsinformationen des Blocks die effektive Kapazität des Blocks umfassen.

8. Verfahren nach Anspruch 5, wobei die Kapazitätsinformationen des Blocks ein Kapazitätskennzeichen des Blocks umfassen, eine Korrespondenz zwischen dem Kapazitätskennzeichen des Blocks und der effektiven Kapazität des Blocks in dem Speicher gespeichert wird; und
das Erhalten (S103), durch die Steuerung (11), einer effektiven Kapazität des Blocks gemäß den Kapazitätsinformationen des Blocks umfasst:
Erhalten, durch die Steuerung, der effektiven Kapazität des Blocks gemäß dem Kapazitätskennzeichen des Blocks und der Korrespondenz zwischen dem Kapazitätskennzeichen des Blocks und der effektiven Kapazität des Blocks.

## Revendications

1. Système de stockage comprenant un contrôleur (11), dans lequel le contrôleur est appliqué dans le système de stockage, le système de stockage comprenant en outre un appareil de mémoire flash (22), l'appareil de mémoire flash (22) comprenant une puce flash, la puce flash comprenant un bloc, le bloc comprenant de multiples pages, et au moins l'une des multiples pages étant une page endommagée ;
le contrôleur (11) comprend une interface de communications (128), une mémoire cache (120) et un processeur (118) ;
l'interface de communications (128) est configurée pour communiquer avec l'appareil de mémoire flash (22) ;
la mémoire cache (120) est configurée pour mémoriser temporairement des requêtes d'écriture en provenance d'un hôte couplé au contrôleur (11) et
le processeur (118) est configuré pour :
recevoir des informations de capacité du bloc qui sont envoyées par l'appareil de mémoire flash (22) ;
obtenir une capacité effective du bloc conformément aux informations de capacité du bloc, la capacité effective du bloc ne comprenant pas une capacité de la page endommagée ;
tamponner de multiples requêtes d'écriture dans la mémoire cache (120) jusqu'à ce qu'une taille de données cibles incluses dans les multiples requêtes d'écriture atteigne la capacité effective du bloc ;
lire les données cibles depuis la mémoire cache (120) ; et
envoyer les données cibles à l'appareil de mémoire flash (22).

2. Système de stockage selon la revendication 1, dans lequel les informations de capacité du bloc comprennent des informations relatives à la page endommagée, les informations relatives à la page endommagée étant utilisées pour indiquer la capacité de la page endommagée, le processeur (118) étant configuré spécifiquement pour obtenir la capacité effective du bloc conformément à une capacité standard prémémorisée du bloc et la capacité de la page endommagée, et la capacité effective du bloc est la capacité standard du bloc moins la capacité de la page endommagée.

3. Système de stockage selon la revendication 1, dans lequel les informations de capacité du bloc comprennent la capacité effective du bloc.

4. Système de stockage selon la revendication 1, dans lequel les informations de capacité du bloc comprennent un fanion de capacité du bloc, le contrôleur (11) comprend en outre une mémoire (122), et une correspondance entre le fanion de capacité du bloc et la capacité effective du bloc est mémorisée dans la mémoire ; et
le processeur (118) est configuré spécifiquement pour obtenir la capacité effective du bloc conformément au fanion de capacité du bloc, et à la correspondance entre le fanion de capacité du bloc et la capacité effective du bloc.

5. Procédé d'écriture de données dans un appareil de mémoire flash (22), le procédé étant appliqué dans un système de stockage, le système de stockage comprenant un contrôleur (11) et l'appareil de mémoire flash (22), l'appareil de mémoire flash (22) comprenant une puce flash, la puce flash comprenant un bloc, le bloc comprenant de multiples pages, et au moins l'une des multiples pages étant une page endommagée ; et le procédé comprenant :
la réception (S102, S202, S302), par le contrôleur (11), d'informations de capacité du bloc qui sont envoyées par l'appareil de mémoire flash (22) ;
l'obtention (S103), par le contrôleur (11), d'une capacité effective du bloc conformément aux informations de capacité du bloc, la capacité effective du bloc ne comprenant pas une capacité de la page endommagée ;
le tamponnage, par le contrôleur (11), de multiples requêtes d'écriture dans une mémoire cache (120) du contrôleur (11) jusqu'à ce qu'une taille de données cibles incluses dans les multiples requêtes d'écriture atteigne la capacité effective du bloc ;
la lecture (S104), par le contrôleur (11), des données cibles depuis la mémoire cache (120) ; et
l'envoi (S105), par le contrôleur (11), des données cibles à l'appareil de mémoire flash (22).

6. Procédé selon la revendication 5, dans lequel les informations de capacité du bloc comprennent des informations relatives à la page endommagée, les informations relatives à la page endommagée étant utilisées pour indiquer la capacité de la page endommagée ; et
l'obtention (S103), par le contrôleur (11), d'une capacité effective du bloc conformément aux informations de capacité du bloc comprend :
l'obtention, par le contrôleur (11), de la capacité effective du bloc conformément à une capacité standard prémémorisée du bloc et la capacité de la page endommagée, la capacité effective du bloc étant la capacité standard du bloc moins la capacité de la page endommagée.

7. Procédé selon la revendication 5, dans lequel les informations de capacité du bloc comprennent la capacité effective du bloc.

8. Procédé selon la revendication 5, dans lequel les informations de capacité du bloc comprennent un fanion de capacité du bloc, une correspondance entre le fanion de capacité du bloc et la capacité effective du bloc est mémorisée dans la mémoire ; et l'obtention (S103), par le contrôleur (11), d'une capacité effective du plan conformément aux informations de capacité du bloc comprend :
l'obtention, par le contrôleur, de la capacité effective du bloc conformément au fanion de capacité du bloc, et de la correspondance entre le fanion de capacité du bloc et la capacité effective du bloc.
